## Europäisches Patentamt
## European Patent Office
## Office européen des brevets

(11) Publication number: **0 177 117**
**B1**

# EUROPEAN PATENT SPECIFICATION

(45) Date of publication of patent specification: **09.08.89**

(51) Int. Cl.⁴: **H 04 N 1/028**

(21) Application number: **85303206.8**

(22) Date of filing: **07.05.85**

(54) **Image sensor.**

(30) Priority: **25.08.84 JP 177089/84**

(43) Date of publication of application:
**09.04.86 Bulletin 86/15**

(45) Publication of the grant of the patent:
**09.08.89 Bulletin 89/32**

(84) Designated Contracting States:
**DE FR GB**

(56) References cited:
**EP-A-0 070 620**
**EP-A-0 148 055**
**US-A-4 271 435**

(73) Proprietor: **FUJI ELECTRIC CO., LTD.**
**1-1, Tanabeshinden, Kawasaki-ku**
**Kawasaki-shi Kanagawa 210 (JP)**
(73) Proprietor: **FUJI ELECTRIC CORPORATE**
**RESEARCH AND DEVELOPMENT LTD.**
**2-1, Nagasaka 2-chome**
**Yokosuka-shi Kanagawa-ken (JP)**

(72) Inventor: **Nishiura, Masaharu**
**35-2 Nagasaka 3-chome**
**Yokosuka-shi Kanagawa-ken 240-01 (JP)**
Inventor: **Nagakusa, Shinichiro**
**763-6 Aza-Nakayama Ooaza-Degawamachi**
**Matsumoto-shi Nagano-ken 390 (JP)**

(74) Representative: **Gordon, Martin et al**
**G.F. Redfern & Company Marlborough Lodge 14**
**Farncombe Road**
**Worthing West Sussex, BN11 2BT (GB)**

Courier Press, Leamington Spa, England.

## Description

This invention relates to an image sensor for reading documents in, for example, a facsimile transmitter.

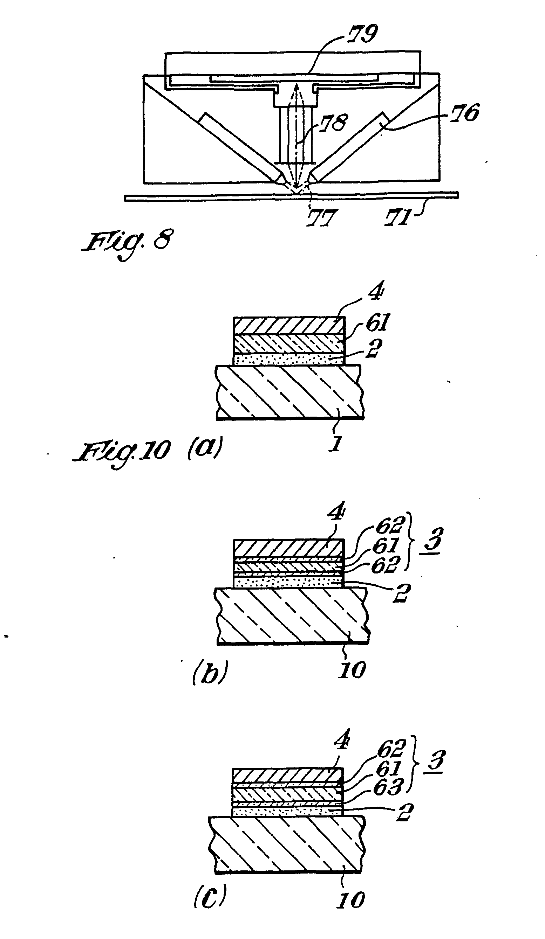

In Fig. 7 there is shown the main components of a document reading arrangement of a facsimile transmitter. A document 71 is irradiated by means of a light source such as a fluorescent lamp 72 and a reduced-scale image of the document is projected to a CCD sensor 75 via a mirror 73 and a lens 74. However, this facsimile transmitter is necessarily large in size (with adverse affects on cost), because the distance between the document 71 and the sensor 75 is long and fine adjustment is required for the optical system.

However, the problems have been reduced by the development of a tightly-coupled image sensor. Fig. 8 is a cross-sectional view of the document reading arrangement of a facsimile transmitter incorporating such an image sensor. In this case, a portion of a document 71 is irradiated with light 77 emitted from a light-emitting diode array 76 and an image of the portion of the document is projected, full size, to the image sensor 79 through a SELFOC lens 78. An output signal of this sensor 79 is processed by a computer and is then output as an image signal. Such an image sensor does not require a sophisticated optical system, is easily adjusted, requires minimal distance between the document and the sensor and is low cost.

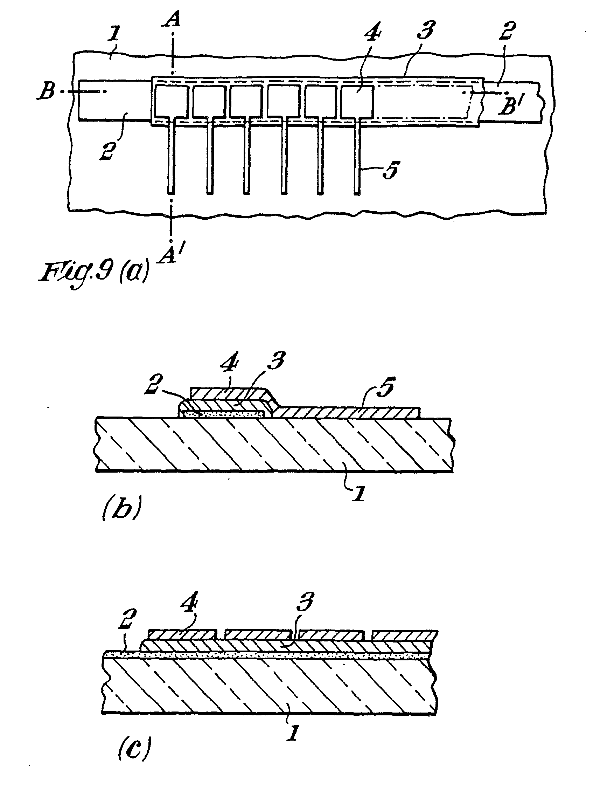

In Fig. 9 there is shown an example of a conventional structure of a tightly-coupled sensor, such as the sensor 79 shown in Fig. 8. This tightly-coupled image sensor is formed on a glass substrate 1 such that a light signal can enter through the glass. On the substrate 1, a transparent electrode 2 is formed by a film of ITO (indium-tin oxide) or of $SnO_2$ (tin oxide) or by a film comprising a stack of layers of both substances. The electrode 2 is formed with a belt-shape by vacuum-deposition and appropriate masking, or by a photo etching method after formation of the transparent electrode over the entire area of the substrate. A column of sensors is formed on the electrode 2. The column of sensors is composed of a sensing area 3 and an electrode 4. The sensing area 3 is formed by an amorphous silicon (a-Si) layer and is formed over the entire area of the column of sensors. The a-Si layer is formed by glow discharge of silane glass, while the patterning of the a-Si layer can be achieved by the photo-etching method. A metal electrode 4 and a terminal portion 5 are formed as patterns on the a-Si layer. A total of eight photo sensors are arranged within each 1mm of column length and therefore 1728 sensors can be provided in the column extending over the width of an A4 size area.

Fig. 10 shows three different types of structure for the a-Si layer comprising the sensing area of such a tightly-coupled image sensor. In Fig. 10(a), a transparent electrode 2, a non-doped a-Si layer 61 with a thickness of about 1 µm to be used as the sensing area, and a metal electrode 4 are stacked on a glass substrate 1. This non-doped a-Si layer (i layer) 61 is formed by glow discharge decomposition of silane glass. In Fig. 10(b), an n-type a-Si layer 62 is formed with a thickness of about 100A as the sensing area, a non-doped a-Si layer 61 is then stacked on the layer 62 with a thickness of about 0.5 µm and then a further n-type a-Si 62 is in turn formed on the stack with a thickness of about 500Å. In Fig. 10(c), a p-type a-Si layer 63 is formed as the sensing area 3 with a thickness of about 100Å, a non-doped a-Si layer is stacked on the layer 63 with a thickness of about 0.5 µm and an n-type a-Si layer 62 is then added to the stack with a thickness of about 500Å. In Figs. 10(a), (c) there are shown electromotive types of sensor and in Fig. 10(b) is shown a photo-conductive type of sensor. Even in the case of a photo-electromotive type, a backward bias is usually applied.

A major problem with the tightly-coupled image sensors described above is that if any one of the large number of sensors (for example 1728 in the case of a column whose length corresponds to A4 width) is defective then the image sensor produces a defective image. It is an object of the invention to produce a tightly-coupled image sensor which is less susceptible to this problem.

Also known is European Patent Specification EP-A-0 148 055 which falls under Article 54, paragraph 3EPC, and discloses an image sensor which has a plurality of mutually parallel columns of sensors each column being composed of a plurality of photo sensors arranged in a straight line and the columns being arranged side-by-side such that corresponding sensors in the various columns form rows at right angles to the columns, means being provided for selecting one of the sensors from each row to provide a respective output signal dependent on light incident on the relevant sensor.

According to this invention there is provided an image sensor which has a plurality of mutually parallel columns of sensors each column being composed of a plurality of photo sensors arranged in a straight line and the columns being arranged side-by-side such that corresponding sensors in the various columns form rows at right angles to the columns, means being provided for selecting one of the sensors from each row to provide a respective output signal dependent on light incident on the relevant sensor, characterised in that either the sensors in each column have a respective common column electrode or the sensor columns have a common first electrode.

The present invention will now be described in greater detail by way of example with reference to the accompanying diagrams, where:-

Fig. 1(a) is a partial plan view of an image sensor embodying the invention;

Fig. 1(b) is a partial sectional view taken along the line A-A' in Fig. 1(a);

Fig. 1(c) is a partial sectional view taken along the line B-B' in Fig. 1(a);

Fig. 2 is a circuit diagram of the image sensor shown in Fig. 1;

Figs. 3(a) to 3(c) are views corresponding to Figs. 1(a) to 1(c) of an image sensor forming a second embodiment of the invention;

Fig. 4 is a partial sectional view of the image sensor shown in Fig. 3 set up for operation;

Fig. 5 is a plan view of an image sensor which forms a third embodiment of the inveniton;

Fig. 6 is a partial sectional view of the image sensor shown in Fig. 5;

Fig. 7 is a perspective view of the document reading arrangement of a conventional facsimile transmitter which does not use a tightly-coupled image sensor;

Fig. 8 is a sectional view of the document reading arrangement of a facsimile transmitter having a tightly-coupled image sensor;

Figs. 9(a) to 9(c) are views corresponding to Figs. 1(a) to 1(c) of a conventional tightly-coupled image sensor; and

Figs. 10(a) to 10(c) are partial sectional views of respective different types of image sensor.

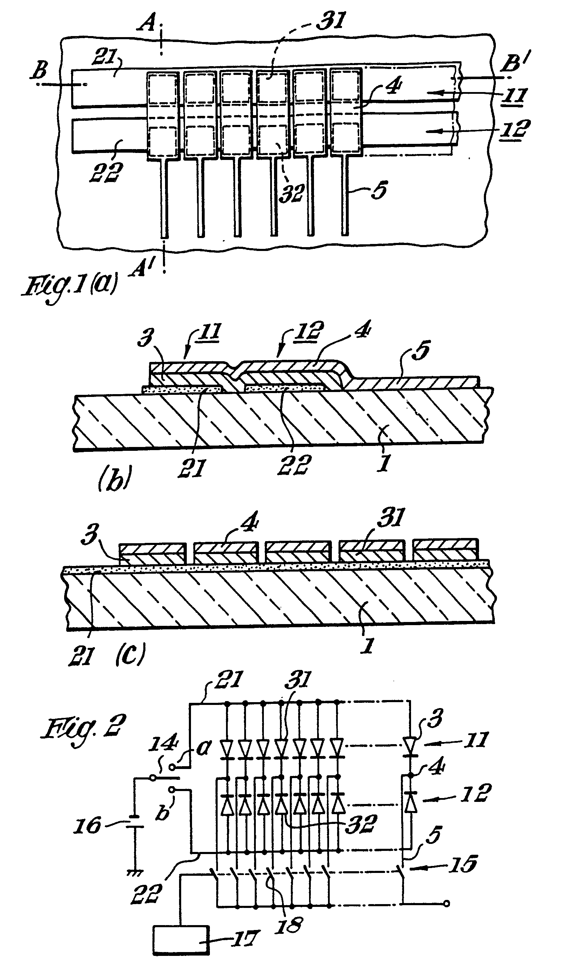

Referring to Fig. 1, rectangular transparent electrodes 21, 22 are formed separately on a glass substrate 1 and the sensing part 3 and metal electrodes 4 are stacked on the electrodes in the same way as described above with reference to Fig. 9. Then a pair of mutually parallel straight-line sensor columns 11, 12 are formed each as described above for the single sensor column shown in Fig. 9. To correspond with an A4 width each of the sensor columns 11, 12 comprises 1728 sensors.

Metal electrodes 4 are provided for the two sensor columns 11, 12 and have terminal portions 5 each of which is common to the electrodes of both sensors arranged in the same row at right angles to the sensor columns.

Accordingly, an output signal from one of the sensors belonging to the sensor column 11 can be extracted via the transparent electrode 21 and the metal electrode 4 while an output signal from one of the sensors belonging to the sensor column 12 can be extracted via the transparent electrode 22 and the metal electrode 4. If a sensor, using the sensing portion 31 of the sensor column 11, is found to be defective, for example, as a result of a check of the sensors then instead, the signal from the sensor in the same row as the faulty sensor and using the sensing portion 32 of the sensor column 12, can be used. Thus it will be appreciated that the sensor columns are arranged in an operational hierarchy.

Fig. 2 is a circuit diagram of the image sensor shown in Fig. 1 using a photo-electromotive type sensing portion. The components which are the same as those in Fig. 1 are given the same references.

Switches 14 and 15 are operated by means of a control unit and when the switch 14 (which is operated cyclically) is set to position a, a voltage is applied (dependent on the incident light) to the sensing portion 31 from a bias power supply 16. At the same time all switches 15 except for a selected switch 18 connected to the sensing portion 31 are closed by means of a scanner circuit 17. The switch 18 is connected to a sensor of the column 11 that is defective. Thereby, output signals are read from all those sensors which are not defective.

When the reflected light from the document shifts to the sensor column 12, the switch 14 is switched to the portion b and all switches 15 are opened except the switch 18 connected to the sensing portion 32 which is closed. Thus the bias voltage is now applied to the sensing portion 32 via the sensors in dependence on the light incident on the latter. However, only the sensor in the column 12 and associated with the switch 18 provides an output data signal. This data signal is input to a computer instead of the corresponding data signal from the sensing portion 31 and then a complete image signal can be formed. Thus data can be read without reducing the reading speed.

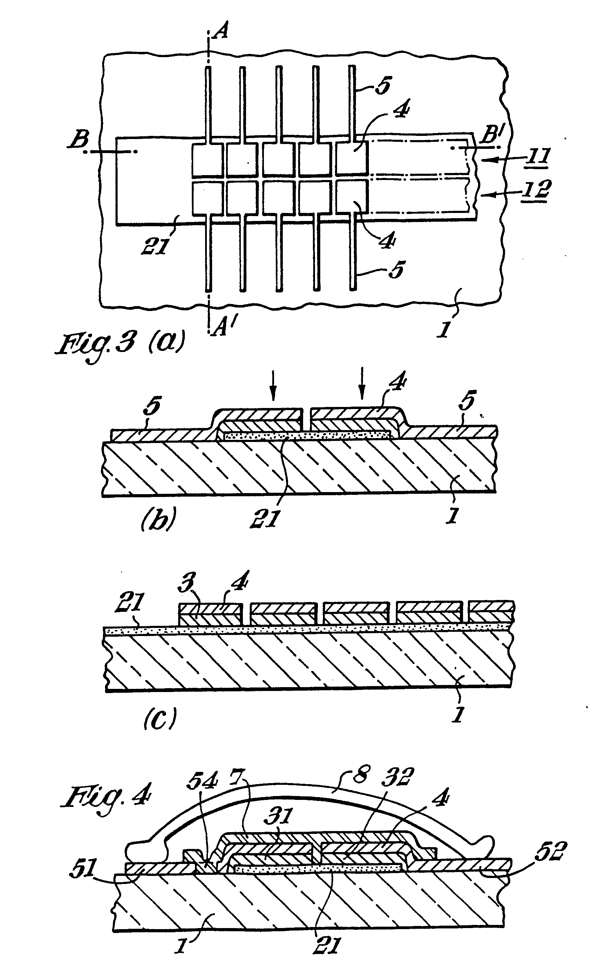

Referring to Fig. 3, in a second embodiment, two separate sensor columns 11, 12 are formed on a single common transparent electrode 21. The metal electrode 4 of each sensor respectively has a terminal portion 5. If, for example, a sensing portion 31 (see Fig. 4) of the sensor column 11 is found (from a routine check) to be defective, then the defective portion can be marked and a laser cutter can be used to cut the relevant terminal portions at the position 54. A YAG can be used for this, thereby enabling the cutting to be done easily with a diameter of several hundreds of μm and an output of several Watts.

The area of the cut can be covered with an insulating film 7 formed by $Si_3N_4$ through decomposition of $CH_3$ and $NH_3$ by the plasma CVD method or by $SiO_2$ through decomposition of $CH_4$ and $O_2$. Thereafter, an appropriate pattern can also be formed by a photo-etching method. Alternatively, the film can also be formed as an insulating film coating by a printing method.

The terminal portion 51 to the outside of the position of the cut 54 and the signal terminal portion 52 connected to sensing portion 32 of the sensor in the sensor column 12 in the same row as the portion 31 are interconnected by means of a wire 8.

As a result, when the light reflected from the document enters the sensor column 11, output signals from the sensors other than the sensor having the defective sensing portion 31 are read, and when the light enters the sensor column 12, an output signal from the unit of sensing portion 32 is read via the terminal portion 52 and the terminal portion 51 through the wire 8, and is processed, together with the data obtained from the sensor column 11, by means of a computer and is then output as an image signal.

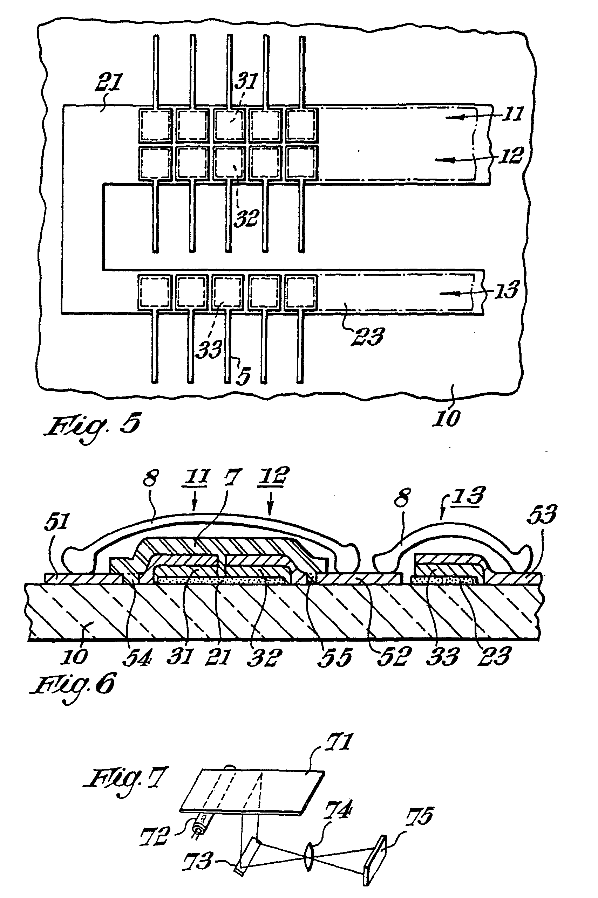

In Fig. 5 there is shown a third embodiment having three sensor columns 11, 12 and 13. The sensor column 13 is formed on a transparent electrode 23 branched from the transparent electrode 21. If, for example, the sensor 31 of the sensor column 11 is known to be defective, by means of a routine check, and if, when the routine check is also conducted on the sensor associated with the sensing portion 32 in the same row as the sensing portion 31 in sensor column 12, the sensing portion 32 is also detected to be defective, then a routine check is also conducted on the sensor having sensing portion 33 in sensor column 13 and in the same row as portions 31, 32. If this sensor 33 is found to be good, the metal electrode 4 is cut at two points 54, 55 as shown in Fig. 6 by a method similar to that described in the case of the embodiment shown in Fig. 4 and the cutting points 54, 55 and the metal electrode 4 on the sensing portions 31, 32 are covered with an insulating film 7.

Thereafter, the sensing portion 33 is connected to the terminal portion 51 via the terminal portions 53, 52 by means of a connecting wire 8. Thus, a photo-current signal from the sensor using the sensing portions 33 of the sensor column 13 can be used in place of the sensors having the sensing portions 31 and 32 of the sensor columns 11 and 12 respectively.

In Fig. 6 an insulating film 7 is not shown covering the sensing portion 33, but its presence there is desirable for preventing a risk of contact between the wire 8 and the adjacent sensor in the same sensor column.

Each of the embodiments described above has a plurality of sensor columns, each consisting of a multiplicity of sensors arranged in a straight line, where if there is a defective sensor in one sensor column, an output signal can be obtained from the sensor in the same row of another sensor column instead of from the defective sensor by the selective operation of switches or selective disconnection of the terminal portion associated with the defective sensor and providing of a connecting wire. Thus, if sensor columns are found to be partly defective, the image sensor as a whole can be considered to be good and the quality of the tightly-coupled image sensor can be much improved.

So the reliability of the image sensor as a whole can be dramatically improved.

This invention is not limited only to image sensors having an a-Si layer. It is clear that this invention can also be adopted in the case where a photo-electric conversion layer or photo-conductive layer consisting of a thin film such as CdS is used in place of the a-Si layer.

Thus the embodiments described above provide an image sensor which has a plurality of mutually parallel comuns (11, 12, 13) of sensors (21, 31, 4; 22, 32, 4) each column being composed of a plurality of photo sensors arranged in a straight line and the columns being arranged side-by-side such that corresponding sensors in the various columns form rows at right angles to the columns, means (15, 17, 18; 54, 55) being provided for selecting one of the sensors from each row to provide a respective output signal dependent on light incident on the relevant sensorso that failure of a sensor in a row can be compensated by the substitution of the signal from another sensor in the same row.

## Claims

1. An image sensor which has a plurality of mutually parallel columns (11, 12, 13) of sensors (31, 32, 33) each column being composed of a plurality of photo sensors arranged in a straight line and the columns being arranged side-by-side such that corresponding sensors (31, 32, 33) in the various columns form rows at right angles to the columns, means (14 to 18) being provided for selecting one of the sensors from each row to provide a respective output signal dependent on light incident on the relevant sensor, characterised in that either the sensors in each column have a respective common column electrode (21, 22) or the sensor columns have a common first electrode (21, 23).

2. An image sensor according to claim 1, characterised in that the sensors (31, 32) in each column (11, 12) have a respective common column electrode (21, 22) and the sensors in each row have a respective common row electrode (4, 5), means (14, 16) being provided for cyclically switching the column electrodes (21, 22) in turn and means (15, 17, 18) being provided for switching said row elecrodes (4, 5) to respective output connections at respective times during the cycle of said column electrode switching means determined in dependence on a predetermined column hierarchy and on which of the sensors (31, 32) in the relevant row is defective.

3. An image sensor according to claim 1, characterised in that all the sensor columns (11, 12, 13) have a common first electrode (21, 23) and the sensors (31, 32, 33) in each row have respective second electrodes (4, 5) which can be selectively connected to respective output connections.

4. An image sensor according to claim 1, characterised in that said first electrode (21, 23) comprises a plurality of mutually parallel branches.

5. A tightly-coupled document reading arrangement for a facsimile transmitter and including an image sensor according to any one of the preceding claims.

## Patentansprüche

1. Bildwandler mit mehreren gegenseitig parallelen Spalten (11, 12, 13) von Abfühlern (31, 32, 33), wobei jede Spalte zusammengesetzt ist aus mehreren in gerader Linie angeordneten Photomeßfühlern und die Spalten derart Seite an Seite angeordnet sind, daß die entsprechenden Abfühler (31, 32, 33) in den verschiedenen Spalten Reihen im rechten Winkel zu den Spalten bilden, einer Einrichtung (14 bis 18) zum Auswählen einer der Abfühler aus jeder Reihe, um abhängig von dem auf den betreffenden Abfühler einfallenden Lichtes ein jeweiliges Ausgangssignal zu liefern, dadurch gekennzeichnet, daß entweder die Abfühler in jeder Spalte eine jeweilige gemeinsame Spalte-Eletrode (21, 22) oder die Abfühlerspalten eine gemeinsame erste Elektrode (21, 23) besitzen.

2. Bildwandler nach Anspruch 1, dadurch gekennzeichnet, daß die Abfühler (31, 32) in jeder Spalte (11, 12) eine jeweilige gemeinsame Spalte-Elektrode (21, 22) und die Abfühler in jeder Reihe eine jeweilige gemeinsame Reihe-Elektrode (4, 5) besitzen und daß eine Einrichtung (14, 16) zum zyklischen abwechselnden Schalten der Spalte-Elektroden (21, 22) und eine weitere Einrichtung (15, 17, 18) vorgesehen ist zum Schalten der Reihe-Elektroden (4, 5) auf die jeweiligen Ausgangsanschlüsse zu den jeweiligen Zeiten während des Zyklus der Einrichtung zum Schalten der Spalte-Elektroden nach der Bestimmung als Funktion einer vorher bestimmten Spalte-Hierarchie sowie derjenigen der Abfühler (31, 32) in der betreffenden Reihe, der schadhaft ist.

3. Bildwandler nach Anspruch 1, dadurch gekennzeichnet, daß sämtliche Abfühlerspalten (11, 12, 13) eine gemeinsame erste Elektrode (21, 23) und die Abfühler (31, 32, 33) in jeder Reihe jeweilige zweite Elektroden (4, 5) besitzen, die selektiv mit den jeweiligen Ausgangsanschlüssen verbunden werden können.

4. Bildwandler nach Anspruch 1, dadurch gekennzeichnet, daß die erste Elektrode (21, 23) mehrere gegenseitig parallele Verzweigungen aufweist.

5. Festgekoppelte Belegleseanordnung für Telefaxsender mit einem nach den vorstehenden Ansprüchen ausgebildeten Bildwandler.

**Revendications**

1. Détecteur d'image comprenant une pluralité de colonnes mutuellement parallèle (11, 12, 13) de capteurs (31, 32, 33), chaque colonne étant composée d'une pluralité de photocapteurs disposés en ligne droite et les colonnes étant disposées côte à côte de manière que les capteurs correspondants (31, 32, 33) des diverses colonnes forment des rangées à angle droit par rapport aux colonnes, des moyens (14 à 18) étant prévus pour sélectionner l'un des capteurs de chaque rangée et obtenir un signal de sortie respectif fonction de la lumière venant frapper le capteur concerné, caractérisé en ce que les capteurs de chaque colonne comprennent une électrode de colonne commune respective (21, 22) ou bien les colonnes de capteurs comprennent une première électrode commune (21, 23).

2. Détecteur d'image selon la revendication 1, caractérisé en ce que les capteurs (31, 32) de chaque colonne (11, 12) comprennent une électrode de colonne commune respective (21, 22) et les capteurs de chaque rangée comprennent une électrode de rangée commune respective (4, 5), des moyens (14, 16) étant prévus pour commuter cycliquement les électrodes de colonne (21, 22) tour à tour et des moyens (15, 17, 18) étant prévus pour commuter lesdites électrodes de rangées (4, 5) sur les connexions de sortie respectives à des moments respectifs pendant le cycle desdits moyens de commutation d'électrodes de colonnes déterminés en fonction d'une hiérarchie de colonnes prédéterminée et de celui des capteurs (31, 32) de la colonne concernée qui est défaillant.

3. Détecteur d'image selon la revendication 1, caractérisé en ce que toutes les colonnes de capteurs (11, 12, 13) comprennent une première électrode commune (21, 23) et les capteurs (31, 32, 33) de chaque rangée comprennent des secondes électrodes respectives (4, 5) qui peuvent être reliées sélectivement à des connexions de sortie respectives.

4. Détecteur d'image selon la revendication 1, caractérisé en ce que ladite première électrode (21, 23) comprend une pluralité de branches mutuellement parallèles.

5. Agencement de lecteur de documents à couplage étroit pour un émetteur de facsimilés comprenant un détecteur d'image selon l'une quelconque des revendications précédentes.

Fig.1 (a)

(b)

(c)

Fig. 2

*A*

*B*
*B'*

*5*

*4*

*11*

*12*

*21*

*4*

*5*

*A'*

Fig. 3 (a)

*1*

*5*
*4*
*5*

*21*

(b)
*21*
*1*

*21*
*3*
*4*

*21*

(c)
*1*

Fig. 4
*54 7*
*8 32*
*31*
*4*

*51*
*52*

*1*
*21*

*Fig. 5*

*Fig. 6*

*Fig. 7*

3

Fig. 8

Fig. 10 (a)

(b)

(c)

Fig.9 (a)

(b)

(c)